(19) **Europäisches Patentamt / European Patent Office / Office européen des brevets**

(11) **EP 4 687 165 A1**

(12) # EUROPEAN PATENT APPLICATION

(43) Date of publication:
04.02.2026 Bulletin 2026/06

(21) Application number: 24191430.8

(22) Date of filing: **29.07.2024**

(51) International Patent Classification (IPC):
*H01H 1/00* (2006.01)   *G01R 31/327* (2006.01)
*H01H 11/00* (2006.01)   *H01H 47/00* (2006.01)
*H01H 71/04* (2006.01)

(52) Cooperative Patent Classification (CPC):
**H01H 11/0062; G01R 31/3274; H01H 1/0015;**
**H01H 47/002; H01H 71/04;** H01H 2071/044

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
- **CILIBRASI, Marco**
**8048 Zürich (CH)**
- **HENCKEN, Kai Alfred**
**79539 Lörrach (DE)**

(74) Representative: **Maiwald GmbH**
**Engineering**
**Elisenhof**
**Elisenstrasse 3**
**80335 München (DE)**

(54) **METHOD FOR DETERMINING A HEALTH CONDITION OF AN ELECTRICAL DEVICE COMPRISING A MECHANICAL ACTUATION SYSTEM**

(57)     The disclosure relates to a method (100) for determining a health condition of an electrical device (10) comprising a mechanical actuation system (11), the method (100) comprising:
- obtaining measurement data indicative of a measured travel curve (1) of the mechanical actuation system (11);
- obtaining model data indicative of a modeled travel curve of the mechanical actuation system (11) in the electrical device (10), the model data being based on a mechanical model (14) of the mechanical actuation system (11); and
- determining the health condition of the electrical device (10) based on the measurement data and the model data.

OPENING

Time [s]

Fig. 4

EP 4 687 165 A1

Description

TECHNICAL FIELD

The present invention generally relates to the field of determining health conditions in electrical devices with mechanical actuation systems, such as but not only circuit breakers, switches, and contactors. In particular, the invention is in the field of prognostics and health management of electrical devices, especially mechanical actuators, where the opening and closing operation of the contacts is often measured and analyzed, but it applies to any electrical device whose motion or, in other words, actuation is measured. Specifically, the present invention relates to a method for determining a health condition of an electrical device comprising a mechanical actuation system, a computer program product, and a data processing system.

BACKGROUND

In this field, usually, data-driven techniques are applied, due to the large amount of data collected and the complex response of an overall travel curve of the mechanical actuator under degradation or faulty behavior. An example is the identification of some main features or characteristics of the travel curves, which are then used for classification, or for studying their evolution. This approach succeeds in detecting the fault or aging of the electrical device but fails in identifying the specific components responsible. It is also rather difficult to use it beyond fault detection, and to determine critical bounds.
Other approaches involve the analysis of the oscillations in the signal via Fourier transform, or also the identification of the main modes via a Principal Component Analysis. All these purely data-driven approaches, meaning models that are data-driven, but that take the physical nature of the system into account only indirectly, do not give satisfactory results, especially because they are not easy to interpret, do not give insight into the precise characterization of the different parts of the device, or do not allow to make predictions of the future evolution of the system.
On the other hand, mechanical-based models, where a "digital twin" of the electrical device is produced with different levels of complexity, may give deeper understanding of the health condition of the electrical device.
However, one of the reasons why up to now a direct fitting of a model has not been attempted is due to the complexity of such models if they are based on real geometries or CAD files. This leads to issues in the identifiability of the parameters and means that many different changes to the system can lead to the same change in the travel curve, which makes any parameter fitting approach not viable.

SUMMARY OF THE INVENTION

The above problem or need is at least partially solved or alleviated by the subject matters of the independent claims of the present disclosure, wherein further examples are incorporated in the dependent claims.
According to an aspect of the present disclosure, there is provided a method for determining a health condition of an electrical device comprising a mechanical actuation system, the method comprising:

- obtaining measurement data indicative of a measured travel curve of the mechanical actuation system;

- obtaining model data indicative of a modeled travel curve of the mechanical actuation system in the electrical device, the model data being based on a mechanical model of the mechanical actuation system; and

- determining the health condition of the electrical device based on the measurement data and the model data.

The method of the first aspect may in particular be an at least partially or fully computer implemented method. This means that at least one, multiple or all of the steps of the method may be carried out by a data processing system, which may comprise one or more computers or computing units, which may be part of the electrical device or not, e.g., integrated therewith or connected thereto. Different steps may be carried out by the same or by different computers. A computer is herein understood as a data processing apparatus or device, which can carry out some, multiple or all steps as defined by the method. Specifically, the obtaining of the measurement data, the model data and/or determining of the health condition may be carried out by the data processing system. Additionally, or alternatively, the obtaining of the measurement data may be carried out by a measurement device or system, which may optionally forward the measurement data to the data processing system such that it may obtain the measurement data.
The invention proposes a new condition monitoring technique based on the use of a mechanical model, in particular a parametric mechanic model, for a mechanical actuation system within an electrical device, such as a circuit breaker. Throughout their lifespan, electrical devices are susceptible to faults arising from both electrical and mechanical wear. The method enables to correlate measurement data, especially the travel curve, with physical parameters that model the electrical device and determine the health condition, in particular to indicate a location and/or nature of aging and failures of the electrical device.
The method of the first aspect of this disclosure thus allows for accurate determination of a health condition of a mechanical actuation system, in particular a mechanical actuator or parts thereof, by using a measured travel curve and a modelled travel curve of the mechanical actuation system, wherein the modelled travel curve is based on a mechanical model of the mechanical actuation system, and the model data may be particularly simple, e.g., by basing the model data on a low-dimensional system of ordinary differential equations.

The use of a simple mechanical model, which in particular is modeled in a suitable simplified way to make parameter estimation possible is an effective technique for determining the health condition. Such a simplified modeling may for example be enabled by having the model data or mechanical model based on a low-dimensional system of ordinary differential equations (ODE) rather than complex models based on real geometries or CAD files, where the geometry is used in order to describe the functional form. Specifically, complex multibody or even FEM model need numerical solvers and are therefore often computationally very demanding and may be too demanding in comparison to the proposed simplified mechanical model. Alternatively, one can start with a formulation of a Lagrangian that allows to reduce the number of dynamical variables (degrees of freedom) taking into account geometric constraints but also simplifying the system overall. We can also make use of reduced-order models that are derived by using a larger amount of either experimental data or detailed simulation models (for example, multi-body simulations). Further, the mechanical model may be chosen to be identifiable with respect to its parameters, in particular mechanical parameters, and/or features, meaning that the modeled travel curve may be uniquely related to the parameters, in particular mechanical parameters, and/or features of the mechanical actuation system. This is in general not possible for more complex models and therefore does not allow them to be used in this way from a fundamental point of view. Such a reduction of the mechanical actuation system to one that is identifiable may be done with the help of available tools or methods, which are well known in the dynamic systems literature.

Making use of this simple mechanical model in the method, a mechanical parameter and/or feature estimation is possible in a robust way ("structural" and "practical" identifiability). The suggested approach is therefore effective in identifying meaningful (i.e., with respect to the travel curve) mechanical parameters of the mechanical actuation system and follow them in time. In this way, changes in the mechanical actuation system, for example, e.g. to the geometry, spring constants or damping coefficients of the mechanical actuation system, are followed and may be easily connected to degradation processes of the electrical device. They may also be used to predict the future evolution of the mechanical actuation system, hence predict when it will reach critical conditions. This generative nature of the model makes it more useful compared to current methods, that are based on outlier detection, as the end of life of the electrical device is linked to the future travel curve and not some threshold parameter, that is difficult to determine, especially in a multi-dimensional space.

For example, the determining of the health condition may comprise adapting the modeled travel curve to reproduce the measured travel curve. Also, the determining of the health condition may comprise determining the health condition based on the thereby acquired adapted modeled travel curve (acquired by means of the adapting of the modeled travel curve to reproduced the measured travel curve). In other words, the method may comprise adapting the modeled travel curve to reproduce the measured travel curve or, in other words, fitting the modeled travel curve to the measured travel curve, for determining the health condition. In this way, it may be ensured that the adapted modeled travel curve reproduces the measured travel curve as good as possible and allows to consequently determine the health condition based on the mechanical parameters of the modeled travel curve, which are indicative for the health condition.

In an example, the method may further comprise predicting a future health condition of the electrical device based on the adapted modeled travel curve by altering or, in other words, modifying one or more mechanical parameters of the model data. Accordingly, the adapted model data with its adapted modeled travel curve has not merely the capability or allows for determining a current health condition, but also has the capability or allows to predict the behavior (predicted modeled travel curve) of the mechanical actuation system and thus its future health condition. For this purpose, one or more mechanical parameters of the model data may be modified or, in other words, altered. Specifically, an evolution of the one or more mechanical parameters may be extrapolated over time, thereby altering the one or more mechanical parameters, and yielding a predicted modeled travel curve, from which the health condition in the future may be determined. This brings some advantages, as the one or more mechanical parameters are evolving in a physical meaningful way. The extrapolated modeled travel curve with the altered one or more mechanical parameters are very realistic, as they are based on the underlying laws of physics. Specifically, by comparing the predicted modeled travel curve with one or more limits imposed by the mechanical actuation system in terms of speed or position, it can be judged whether they are out of range or not, and therefrom the end-of-life may be estimated.

In an example, the mechanical model, in particular the adapting of the modeled travel curve to reproduce the measured travel curve, may be predominantly based on mechanical parameters influencing the travel curve of the mechanical actuation system. In other words, the adapting or modeling mostly or optionally only includes those mechanical parameters that have an influence on the travel curve of the mechanical actuation system. This further allows that the modeled travel curve may be uniquely related to the relevant mechanical parameters and thus be identifiable.

In an example, the mechanical model may be comprising a number of degrees of freedom in the range of 1 to 10, in particular in the range of 1 to 5. The degrees of freedom are in particular mechanical degress of freedom with respect to the mechanical or actuation movement of the mechanical parts or elements of the actuation system. Hence, the mechanical model is particularly simple and allows to easily determine the health condition.

In an example, the mechanical model may be comprising a number of mechanical parameters of the mechanical actuation system in the range of 2 to 100, in particular in the range of 5 to 80, more particularly in the range of 7 to 50. Hence, the mechanical model is particularly simple and allows to easily determine the health condition.

In an example, the mechanical model may be modeling the mechanical actuation system with one or more of: an elastic element, a non-elastic element, a spring, a damper, a mass, a friction element, or a connection element. Generally, the elastic element may be elastically extended or tensionsed from a starting position and move back to the starting position elastically, while the non-elastic element may be static and not extended or tensioned elastically. Additionally, the mechanical model may be modeled including one or more other features, e.g., constraints, of the actuation motion, e.g., geometrical constraints, material constraints, and similar.

In an example, the measured travel curve may be indicative of a travel path of the mechanical actuation system over time. Thus, the measured travel curve may also be indicative of a degradation of the travel path of the mechanical actuation system over time since the travel path over time will typically change with the wear of the mechanical actuation system over time of usage. The travel path is a physical path of the mechanical actuation system e.g. in millimeters and may be recorded over time, for example, milliseconds, by a measurement system or unit.

In an example, the mechanical actuation system may be configured to mechanically close or open an electrical contact of the electrical device. For this purpose, the mechanical actuation system may be configured to travel a path over time between a closed and open position, in which the electrical contact is closed or opened.

In an example, the electrical device may be from one of: a circuit breaker, a switch, and a contactor.

In an example, the measurement data may be obtained from a measurement unit of the electrical device. The measurement unit may for example be one or more of: a rotary encoder, a linear encoder, a position sensor, or an optical sensor. Specifically, the measurement unit may be depending on the type of actuation or actuation motion that is being carried out by the mechanical actuation system. For example, in case of a rotary actuation motion by the mechanical actuation system to open or close an electrical contact of the electrical device, the measurement unit may be a rotary encoder, which may measure or record the travel path of the mechanical actuation system, including one or more mechanical parts such as a contact thereof, over time, resulting in the measured travel curve of the mechanical actuation system.

According to a second aspect of this disclosure, there is provided a computer program product comprising instructions which, when the program is executed by a data processing system, cause the data processing system to carry out the method according to the first aspect of this disclosure.

The computer program product may be a computer program as such, meaning a computer program consisting of or comprising a program code to be executed by the computer.

Alternatively, the computer program product may be a product such as a data storage, in particular a computer-readable data storage medium, on which the computer program may be temporarily or permanently stored.

According to a third aspect of this disclosure, there is provided a data processing system configured to carry out the method according to the first aspect of this disclosure.

The data processing system may comprise one or more computers as previously described and, optionally, the computer program product of the second aspect of this disclosure.

According to a fourth aspect of this disclosure, there may be provided an electrical system comprising an electrical device comprising a mechanical actuation system and a measurement unit, and the data processing system of the third aspect of this disclosure.

It is noted that the above aspects, examples and features may be combined with each other irrespective of the aspect involved.

The above and other aspects of the present disclosure will become apparent from and elucidated with reference to the examples described hereinafter.

## BRIEF DESCRIPTION OF THE DRAWINGS

Exemplary embodiments will be further described with reference to Figures, wherein:

Figure 1 shows an electrical system;
Figure 2 shows a method for determining a health condition of an electrical device of the electrical system of Fig. 1;
Figure 3 shows a mechanical actuation system of the electrical device of the electrical system of Fig. 1;
Figure 4 shows a measured travel curve and a modeled travel curve for the electrical system of Fig. 1; and
Figure 5 shows a predicted travel curve for the electrical system of Fig. 1.

The Figures are schematic only and not true to scale. In principle, identical or like parts, elements and/or steps are provided with identical or like reference numerals in the Figures.

## DETAILED DESCRIPTION OF THE INVENTION

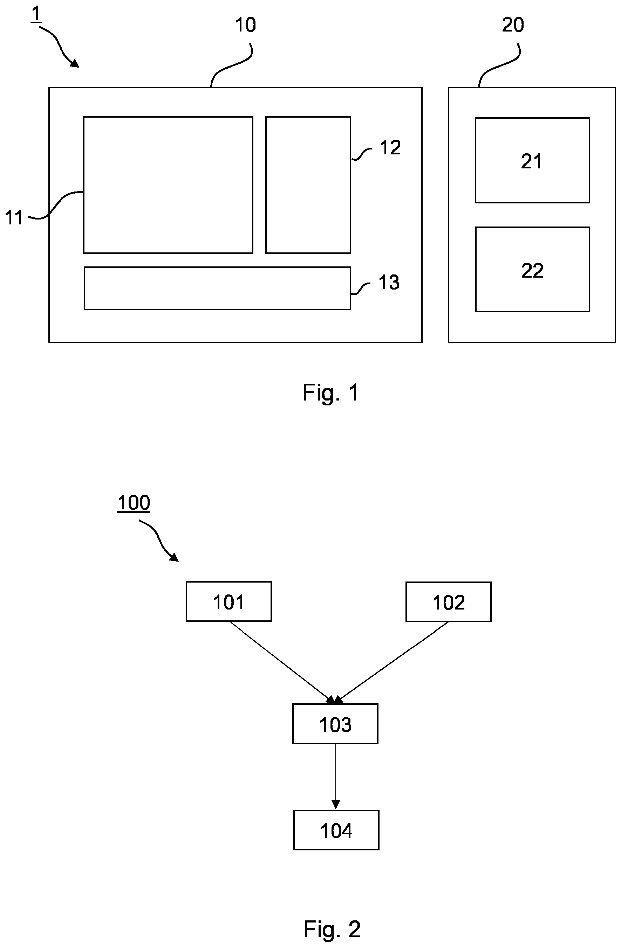

Figure 1 schematically shows an electrical system 1 exemplary comprising an electrical device 10 with a mechanical actuation system 11 and a measuring unit 12. Further, in this example, the electrical device 10 comprises an electrical part in the form of an electrical contact 13. The mechanical actuation system 11 may be configured to close and open the electrical contact 13 of the electrical device 10. Hence, for example, the electrical device 10 may be in the form of a circuit breaker, contactor or switch but is not limited to these examples. Alternatively, the electrical contact 13 may be any other electrical part of the electrical device 10.

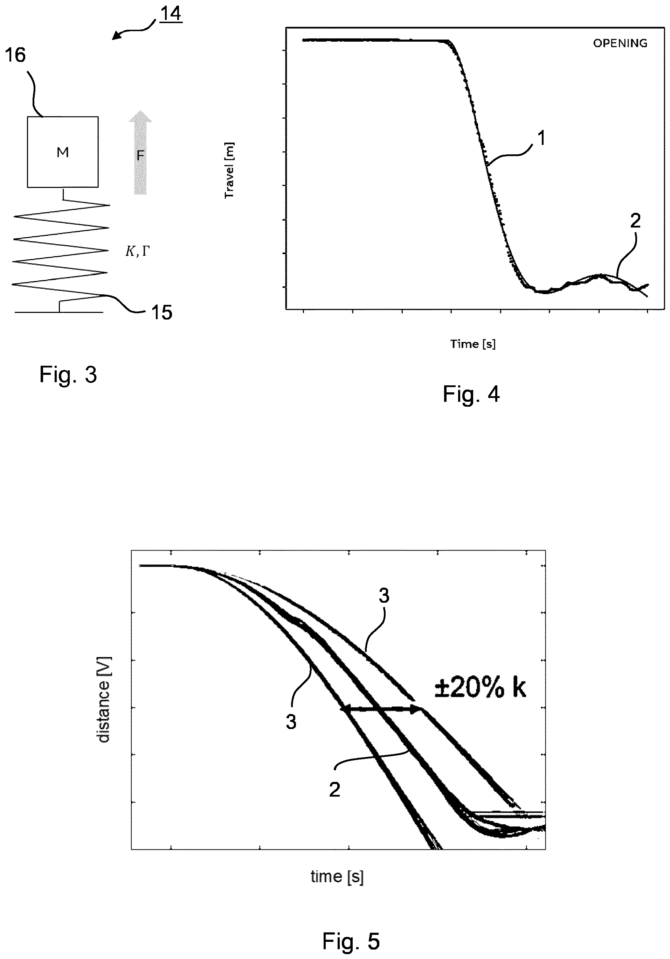

The measuring unit 12 may be configured to obtain measurement data indicative of a measured travel curve 1 of the mechanical actuation system 11 (see Fig. 4). The measured travel curve may be a travel path measured as a distance, e.g., in meters, millimeters or similar, over time, e.g., measured in seconds, milliseconds or similar (see Fig. 4). For this purpose, the measuring unit 12 may measure the travel path of at least one moving mechanical part or portion of the mechanical actuation system 11 over time. Generally or depending on the type of actuation movement any one of a rotary encoder, a linear encoder, a position sensor, or an optical sensor but not limited thereto may be used as measurement unit 12.

A data processing system 20 may be part of the electrical system 1. The data processing system 20 may be connected to the electrical device 10, e.g., via a wire or wirelessly, in particular to the measuring unit 12 of the electrical device for obtaining the measurement data therefrom.

The data processing system 20 may comprise a data processing device 21, in particular in the form of a processing or computing unit or a processor and a computer, and/or a computer program product 22, e.g., in the form of a computer program as such or in the form of a computer-readable storage medium, having stored thereon the computer program. When the computer program product 22 is executed by the data processing device 21, the method 100 shown in Fig. 2 is executed.

One background of the method 100 is that electrical devices 10 such as the one of Fig. 1, in particular their mechanical actuation systems 11, are subjected to wear and thus degradation over their lifetime. Accordingly, their health condition may change over time. Specifically, the electrical devices 10 may fail over time or generally develop faulty conditions. To avoid replacing healthy electrical devices 10 and determine poor health conditions which may lead to a fault too early, it is desirable to determine the health condition of such electrical devices 10.

Figure 2 schematically and exemplary illustrates a method 100 solving the aforementioned. Namely, the method 100 may be for determining a health condition of the electrical device 11. The heatlh condition, in particular a fault condition, may be associated with or relate to a degraded or aged state, in particular but not only in terms of wear in one or more mechanical parts or elements of the mechanical actuation system 11 due to its mechanical working principle. As such, a fault does not necessarily need to occur and be recognized as such. However, early recognition of a poor health condition or fault condition, i.e., that the electrical device 10 may experience the fault, may be beneficial, because then the electrical device 10 may be repaired, replaced or similar before an actual fault occurs based on its fault condition..

For this purpose, the method 100 comprises, in a step 101, obtaining measurement data. The measurement data may be indicative of the measured travel curve 1 of the mechanical actuation system 11. Fig. 4 shows the measured travel curve 1 in the form of or, in other words, with its measured data points of travel (path) in meter over time in seconds, and exemplary for the opening of the electrical contact 13. Alternatively, or additionally, the measured travel curve 1 may be for the closing of the electrical contact 13. The measurement data may be obtained by the measurement unit 12 and/or the data processing system 20, e.g., the measurement data being forwarded from the measurement unit 12 to the data processing system 20. The measurement data may accordingly represent, reflect and/or comprise a travel curve of a travel path of a mechanical part of the mechanical actuation system 11 over time of the operation of the electrical device 10.

Further, the method 100 comprises, in a step 102, obtaining model data indicative of a modeled travel curve of the mechanical actuation system 11 in the electrical device 10, the model data being based on a mechanical model 14 of the mechanical actuation system 11 (see Fig. 3). The model data may be obtained, in particular determined, more particularly modeled, by the data processing system 20. The step 102 may be carried out before, after or simulatenously to step 101 of the method 100.

In particular, the mechanical model 14 or, generally, the model data may be based on on a low-dimensional system of ordinary differential equations. For example, two or more, e.g., up to twenty or ten, ordinary differential equations may be part of the low-dimensional system. Hence, the mechanical model 14 may be a simplified mechanical model compared to more complex CAD or FEM models of the electrical device 10, for example. More specifically, the mechanical model 14 may be predominantly based on mechanical parameters which are influencing the travel curve 1 as measured of the mechanical actuation system 11.

For example, the mechanical model 14 may be comprising a number of mechanical parameters of the mechanical actuation system 11 in the range of 5 to 100, further simplifying the mechanical model and making it identifiable such that the mechanical parameters have a strong correlation to the modeled travel curve 1. Also, the mechanical actuation system 11 may be comparatively simple in that it has e.g. a number of degrees of freedom in the range of 1 to 10, specifically 1 to 5, and/or modeling the mechanical actuation system 11, specifically its mechanical parts or generally its actuation mechanism, with few simple mechanical elements, such as but not limited to any one or more of an elastic element, a non-elastic element, a spring, a damper, a mass, a friction element, or a connection element.

An exemplary mechanical actuation system 11 is illustrated In Fig. 3. This mechanical actuation system 11 may be modeled using several mechanical elements, e.g., two spring elements 15 and two masses 16 as shown in Fig. 3. The resulting mechanical model 14 may be indicative of a modeled travel curve for the mechanical actuation system 11, which may be a computer-generated travel curve rather than the actual or measured travel curve 1 seen in Fig. 4 and being indicative of the health state or condition of the electrical device 10.

In a step 103 of method 100, which may follow steps 101 and 102, the health condition may be determined, based on the measurement data and the model data. Step 103 may be carried out by the data processing system 20.

For example, the determination of the health condition in step 103 may comprise adapting the modeled travel curve to an adapted modeled travel curve 2 as seen in Fig. 4 to reproduce the measured travel curve 1, in particular as precisely as possible as may be seen in Fig. 4, where the adapted modeled travel curve 2 substantially fits or reproduces the measured travel curve 1. In other words, the step 103 may comprise that the modeled travel curve is fitted to represent the measured travel curve 1. The modeled travel curve and the adapted model travel curve 2 may be for the opening and/or closing of the electrical contact 13.

In this way, the mechanical model 14 with its mechanical parameters is optimized to reproduce or represent the actual or measured travel curve 1 of the mechanical actuation system 11. Hence, the mechanical model 14 represents as closely as possible or, in other words, as accurately as possible the current health condition or state of the mechanical actuation system 11. Hence, the mechanical parameters of the mechanical model 14, at least or specifically the ones which are influencing the travel curve, may be used in order to assess the health condition, since these are indicative for the health condition.

Consequently, the method 100 may comprise in step 103 or generally for the determination of the health condition, that the health condition is determined based on the adapted modeled travel curve 2, specifically its or the mechanical model's 14 mechanical parameters, which are indicative for the health condition. Examples of such mechanical parameters are shown in Fig. 3 next to the exemplary mechanical elements in the form of spring constants $K_1$, $K_2$, masses $M_a$, $M_b$ and/or force F. In this way, based on the mechanical parameters determined for the mechanical model 14 to reproduce or fit the measured travel curve 1, the health condition may be determined, specifically the degradation or wear of the mechanical parts of the mechanical actuation system 11 and if it may be necessary to replace or repair the electrical device 10 now or any time soon.

Also, or alternatively, it may be possible to predict a future health condition of the electrical device 10 based on the adapted modeled travel curve 2. For this purpose, one or more mechanical parameters of the adapted model data or, in other words, adapted modeled travel curve 2, may be altered in order to represent one or more predicted modeled travel curves 3 as exemplary shown in Fig. 5. For example, the mechanical parameters may be changed to predict the health condition after 100, 1000 or more mechanical actuations, by means of which due to wear e.g. a friction or similar in the mechanical actuation system 11 may increase and thus the health condition may be worsened.

Specifically, Fig. 5 shows such two exemplary predicted modeled travel curves 3. In the example of Fig. 5, compared to the adapted modeled travel curve 2 of Fig. 4, one or more of the mechanical parameters, specifically one or more of the spring constants K in this example, have been decreased and increased by exemplary 20%, to arrive at two predictions in form of a left predicted modeled travel curve 3 and a right predicted modeled travel curve 3. Hence, the prediction represents a scenario of degradation over time of one or more of the mechanical parts or elements, in particular spring elements, of the mechanical actuation system 11 within a bandwith prediction of 20% decrease and increase of the spring constant K.

Specifically, in a detailed example, the method 100 has been applied to low and/or medium voltage circuit breakers, containing actuation mechanics for a typical medium voltage breakers as electrical devices 10. In this case, the device structure for the mechanical model 14 has been simplified as exemplary shown in Fig. 3. For example, assuming constant geometry and stiff components, the motion may be described by only one or two dynamic variables, depending on whether constraints are active or not, as most of the mechanical elements can be treated as rigidly connected. The description is then in the form of a low-order dynamic system, with different dynamic equations for different parts of the motion.

The method 100 models the mechanism via a system of parametric ordinary differential equations, where each variable may describe one of the degrees of freedom of the mechanical actuation system 11. The mechanical actuation system 11, such as in a low or medium voltage circuit breaker, including their geometric constraints, may be modeled via analytical equations. The mechanical parameters represent the properties or features of the electrical device 10 itself. A model of a circuit breaker mechanism suitable for this method is the exemplary one shown in Fig. 3, where one mass 14 is connected to one damped spring and to a fixed frame. Here, the mass describes the inertia of the drive mechanism, the main shaft, and the levers to the push rods. The spring 15 attached to the fixed frame describes the opening spring. As only one travel curve is measured in this example, the three phases may be combined into a common one. This mechanical actuation system 11 is described by ordinary differential equations, which can be solved analytically or numerically. In particular, we have

$$M\ddot{x} = -K(x - x_0) - \Gamma\dot{x} + F$$

where $x$ is the position of the mass $M$, $K$ is the spring constant, $\Gamma$ is the damping coefficient, $x_0$ the unstretched length of the spring. $F$ describes the additional force applied by the closing spring to initiate the closing operation. The system includes also a model for the collision between the push rod and the fixed contact as an inelastic collision. Quantities may be normalized by factoring out the mass, i.e. $K = Mk$ and $\Gamma = M\gamma$. In this way, the system 11 can become identifiable.

Despite being a very simple mechanical model 14, it does reproduce the data very well as seen in Fig. 4 when fitted to it. The parameter values from the fit give a clear estimate of the health condition of the electrical device 10, and their change in time is useful to track aging and detect faults. Thanks to its simplicity, the mechanical model is very fast and robust to fit and easy to interpret, proving to be an extremely effective method.

This approach has been tested with both normal aging and fault cases, giving always satisfactory results in detecting parameters and determining their evolution. In addition, such systems 11 are accessible to a formal determination of their identifiability with respect to the mechanical parameters. Sometimes this may not be possible. Only specific combinations of mechanical parameters can be uniquely identified, so only those are incorporated in the mechanical parameter set. Alternatively, physical parameters, that are expected to be fixed and not change during degradation, may be fixed in the ordinary differential equations.

Such a reduction of the mechanical system to one that is identifiable can be done with the help of available tools or methods. These are based e.g. starting from multi-body simulation. An alternative is the formulation of a Lagrangian function incorporating geometry and linked motion. Whereas such tools answer the question of (global) identifiability, the practical one may be checked as well. This can be done using simulation studies. Due to the linear nature of the mass-spring-damper system, the general mathematical theory is applicable. This is more complex in case of a generalization to a non-linear one.

Parameter estimation may follow the usual optimization approach. The simplest one is the (nonlinear) Least-Square approach. More complex ones, incorporating the knowledge of parameter ranges are helpful to improve the overall accuracy and robustness of the fit, but also aiding in the interpretation.

Compared to data-driven method, the method 100 has the advantage of connecting changes in the travel curve to specific changes in the device parameters. On the other hand, more complex multi-body models are better at capturing the details of the travel curves but are in general too complex to be identifiable, leading to difficulties in both their interpretation and predictive capabilities.

In addition, the simplified model has the capability to predict the behavior (travel curve) of the device 10 for other parameter values, especially the expected future form from the extrapolation of the current evolution, as described herein. This brings some advantages, as the parameters are evolving in a physical meaningful way. The extrapolated travel curves are more realistic, as they are based on the underlying laws of physics. By comparing these future travel curves, with limits imposed by the system in terms of speed or position, it can be judged whether they are out of range and therefore the end-of-life can be estimated.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art and practicing the claimed invention, from a study of the drawings, the disclosure, and the claims.

As used herein, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of", in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of" may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]". Further, as used herein, phrases such as "based on", "related" or "relating", "associated" and similar are not to be seen exclusively in terms of the entities, elements and/or steps to which they are referring, unless otherwise stated. Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

The designation of methods and steps as first, second, etc. as provided herein is merely intended to make the methods and their steps referenceable and distinguishable from one another. By no means does the designation of methods and steps constitute a limitation of the scope of this disclosure. For example, when this disclosure describes a third step of a method, a first or second step of the method do not need to be present yet alone be performed before the third step unless they are explicitly referred to as being required per se or before the third step. Moreover, the presentation of methods or steps in a certain order is merely intended to facilitate one example of this disclosure and by no means constitutes a limitation of the scope of this disclosure. Generally, unless no explicitly required order is being mentioned, the methods and steps may be carried out in any feasible order. Specifically, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In the context of the present invention any numerical value indicated is typically associated with an interval of accuracy that the person skilled in the art will understand to still ensure the technical effect of the feature in question. As used herein, the deviation from the indicated numerical value is in the range of $\pm$ 10%, and preferably of $\pm$ 5%. The aforementioned deviation from the indicated numerical interval of $\pm$ 10%, and preferably of $\pm$ 5% is also indicated by the terms "about" and "approximately" used herein with respect to a numerical value.

Any reference signs in the claims should not be construed as limiting the scope.

## Claims

1.  A method (100) for determining a health condition of an electrical device (10) comprising a mechanical actuation system (11), the method (100) comprising:

    - obtaining measurement data indicative of a measured travel curve (1) of the mechanical actuation system (11);
    - obtaining model data indicative of a modeled travel curve of the mechanical actuation system (11) in the electrical device (10), the model data being based on a mechanical model (14) of the mechanical actuation system (11); and
    - determining the health condition of the electrical device (10) based on the measurement data and the model data.

2.  The method (100) of claim 1, the model data being based on a low-dimensional system of ordinary differential equations.

3.  The method (100) of claim 1 or 2, wherein the determining of the health condition comprises adapting the modeled travel curve to reproduce the measured travel curve and determining the health condition based on the thereby aquired adapted modeled travel curve (2).

4.  The method (100) of claim 3, wherein the method (100) further comprises:

    - predicting a future health condition of the electrical device based on the adapted modeled travel curve by altering one or more mechanical parameters.

**5.** The method (100) of any one of claims 3 or 4, the adapting of the modeled travel curve being predominantly based on mechanical parameters influencing the travel curve of the mechanical actuation system (11).

**6.** The method (100) of any one of the previous claims, the mechanical model comprising a number of degrees of freedom in the range of 1 to 10.

**7.** The method (100) of any one of the previous claims, the mechanical model comprising a number of mechanical parameters of the mechanical actuation system (11) in the range of 2 to 100.

**8.** The method (100) of any one of the previous claims, the mechanical model modeling the mechanical actuation system (11) with one or more of: an elastic element, a non-elastic element, a spring (15), a damper, a mass (16), a friction element, or a connection element.

**9.** The method (100) of any one of the previous claims, the measured travel curve (1) being indicative of a travel path of the mechanical actuation system (11) over time.

**10.** The method (100) of any one of the previous claims, the mechanical actuation system (11) being configured to mechanically close or open an electrical contact (13) of the electrical device (10).

**11.** The method (100) of any one of the previous claims, the electrical device (10) being from one of: a circuit breaker, a switch, or a contactor.

**12.** The method (100) of any one of the previous claims, the measurement data being obtained from a measurement unit (12) of the electrical device (10).

**13.** The method (100) of claim 12, the measurement unit (12) being one or more of: a rotary encoder, a linear encoder, a position sensor, or an optical sensor.

**14.** A computer program product (21) comprising instructions which, when executed by a data processing system (20), cause the data processing system (20) to carry out the method (100) of any one of the previous claims.

**15.** A data processing system (20) configured for carrying out the method (100) of any one of claims 1 to 13.

**Fig. 1**

**Fig. 2**

Fig. 3

Fig. 4

Fig. 5

# EUROPEAN SEARCH REPORT

**Application Number**

EP 24 19 1430

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 923 309 A1 (ABB POWER GRIDS SWITZERLAND AG [CH]) 15 December 2021 (2021-12-15) * paragraphs [0004] - [0068]; figures 1, 2 * ----- | 1-15 | INV. H01H1/00 G01R31/327 H01H11/00 H01H47/00 H01H71/04 |
| X | US 2022/392721 A1 (LOPEZ SERGIO [NL] ET AL) 8 December 2022 (2022-12-08) * paragraphs [0007] - [0056]; figures 1-3 * ----- | 1-15 | |

**TECHNICAL FIELDS SEARCHED (IPC)**

H01H
G01R

The present search report has been drawn up for all claims

| Place of search | Date of completion of the search | Examiner |
|---|---|---|
| Munich | 18 December 2024 | Ledoux, Serge |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 24 19 1430

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2024

| Patent document cited in search report | | Publication date | Patent family member(s) | | Publication date |
|---|---|---|---|---|---|
| EP 3923309 | A1 | 15-12-2021 | EP | 3923309 A1 | 15-12-2021 |
| | | | WO | 2021250280 A1 | 16-12-2021 |
| US 2022392721 | A1 | 08-12-2022 | CN | 115298784 A | 04-11-2022 |
| | | | EP | 3822999 A1 | 19-05-2021 |
| | | | JP | 7489460 B2 | 23-05-2024 |
| | | | JP | 2023501650 A | 18-01-2023 |
| | | | US | 2022392721 A1 | 08-12-2022 |
| | | | WO | 2021094226 A1 | 20-05-2021 |

EPO FORM P0459

For more details about this annex : see Official Journal of the European Patent Office, No. 12/82